Europäisches Patentamt

European Patent Office

Office européen des brevets

(19)

(11) Veröffentlichungsnummer: **0 256 315 B1**

(12) **EUROPÄISCHE PATENTSCHRIFT**

(45) Veröffentlichungstag der Patentschrift: **29.01.92**

(21) Anmeldenummer: **87110230.7**

(22) Anmeldetag: **15.07.87**

(51) Int. Cl.5: **H01L 21/82**, H01L 21/76, H01L 27/06

(54) **Integrierte Bipolar- und komplementäre MOS-Transistoren auf einem gemeinsamen Substrat enthaltende Schaltung und Verfahren zu ihrer Herstellung.**

(30) Priorität: **13.08.86 DE 3627509**

(43) Veröffentlichungstag der Anmeldung:
**24.02.88 Patentblatt 88/08**

(45) Bekanntmachung des Hinweises auf die Patenterteilung:
**29.01.92 Patentblatt 92/05**

(84) Benannte Vertragsstaaten:
**DE FR GB IT SE**

(56) Entgegenhaltungen:
**EP-A- 0 139 266**

**ELECTRONICS, Band 42, Nr. 6, 17. März 1969, Seiten 185-186, New York, US; "Monolithic IC puts out 18 watts"**

**S.M. SZE: "Physics and properties of semi-conductors", 2. Auflage, 1981, Seite 32, John Wiley & Sons, US**

**IBM TECHNICAL DISCLOSURE BULLETIN, Band 25, Nr. 3B, August 1982, Seiten 1482-1484, New York, US; H.S. BHATIA et al.:**

"Poly filled trench isolation"

(73) Patentinhaber: **SIEMENS AKTIENGESELL-
SCHAFT
Wittelsbacherplatz 2
W-8000 München 2(DE)**

(72) Erfinder: **Neppl, Franz, Dr.
St. Ouirin-Platz 6
W-8000 München 90(DE)**
Erfinder: **Winnerl, Josef, Dr.
Schubertstrasse 2
W-8300 Landshut(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine integrierte Bipolar- und komplementäre MOS (= CMOS)-Transistoren auf einem gemeinsamen Substrat enthaltende Schaltung, bei der für die Aufnahme der p- bzw. n-Kanal-Transistoren im p- bzw. n-dotierten Substrat n- bzw. p-dotierte Wannen vorgesehen sind und die n- bzw. p-dotierten Wannen isolierte npn- bzw. pnp Bipolartransistoren enthalten, wobei die n- bzw. p-dotierten Wannen den Kollektor des Transistors bilden, sowie Verfahren zu ihrer Herstellung. Eine solche integrierte Schaltung und ein Verfahren zu ihrer Herstellung ist beispielsweise aus EP-A-0 139 266 bekannt.

Sollen auf einem Chip gleichzeitig Bipolartransistoren und komplementäre MOS (= CMOS)-Transistoren hergestellt werden, so wird in der Regel von einem n-Wannen-CMOS-Prozeß ausgegangen und die Emittergebiete und Basisanschlüsse der Bipolartransistoren werden gleichzeitig mit den Source- und Drain-Gebieten der MOS-Transistoren implantiert und mit Metall kontaktiert. Ein solcher Prozeß ist beispielsweise in der europäischen Patentanmeldung Nr. 86 10 64 86.3 (EP-A-0 204 979) vorgeschlagen worden. Bei diesem Prozeß werden in die n-dotierten Wannen npn-Bipolartransitoren gelegt, wobei die n-Wanne den Kollektor des Transistors bildet und vergrabene $n^+$-dotierte Zonen bedeckt, die im Bipolartransistorbereich durch tiefreichende Kollektoranschlüsse angeschlossen werden. Der vergrabene Teil und der Kollektoranschluß wird bei diesem Prozeß vor der Wanne erzeugt. Die Wannenimplantation ist selbstjustierend zur Implantation des ringförmig in die Wanne gelegten tiefen Kollektoranschlusses. Dadurch ergibt sich eine Verringerung des Kollektorbahnwiderstandes, sowie eine erhöhte Latch-up-Festigkeit.

Bei Bipolar-Technologien mit diffundierten Kollektoren und bei CMOS- bzw. BICMOS-Schaltkreisen wird aber die Packungsdichte begrenzt durch den Abstand benachbarter Kollektor- bzw. CMOS-Wannen. Der minimale Abstand benachbarter Wannen wird nämlich bestimmt durch die laterale Ausdiffusion von Wannen, von eventuell vorhandenen buried layers (das sind vergrabene Zonen) und Kollektoranschlußimplantationen, sowie durch die Ausdehnung der Verarmungszone der Wannen-Substrat-Übergänge ins Substrat.

Abhilfe könnte dadurch geschaffen werden, daß eine Erhöhung der Substratdotierung zwischen den Wannen bzw. buried layers vorgenommen wird. Dies vermindert zwar die Ausdehnung der Verarmungszonen im Substrat und kann die laterale Ausdiffusion teilweise kompensieren, führt aber zwangsfläufig zur Erhöhung der Kollektor-Substrat-Kapazität.

Aus IBM Technical Disclosure Bulletin, Bd. 25, Nr. 3B, August 1982, S. 1482 - 1484, New York, US; H.S. Bhatia et al.: "Poly filled trench isolation" ist bekannt, Schaltungselemente in einem Substrat durch mit Polysilizium gefüllten Gräben gegeneinander zu isolieren. Dazu werden nach entsprechender Maskierung Gräben geätzt, an deren Seitenwänden Siliziumoxid abgeschieden wird. Anschließend werden die Gräben mit dotiertem Polysilizium aufgefüllt. Zur Planarisierung wird die Oberfläche abgeätzt.

Die Aufgabe, die der Erfindung zugrundeliegt, besteht in der Schaffung einer integrierten CMOS-Transistoren- und Bipolartransistoren auf einem Chip enthaltenden Schaltung, bei der neben einer weiteren Erhöhung der Packungsdichte durch Unterdrückung der lateralen Ausdiffusion aus den Wannenbereichen bei gleichbleibenden Transistoreigenschaften die Latch-up-Festigkeit erhöht wird.

Desweiteren ist es Aufgabe der Erfindung, Verfahren zur Herstellung dieser Schaltung anzugeben, welche in einfachen, maskensparenden Prozeßschritten durchführbar sind.

Die gestellte Aufgabe wird durch eine integrierte Schaltung der eingangs genannten Art gelöst, die dadurch gekennzeichnet ist, daß sowohl die, die p- bzw. n-Kanal-Transistoren aufnehmenden n- bzw. p-dotierten Wannen, als auch die, die npn- bzw. pnp-Bipolartransistoren enthaltenden Wannen im Substrat von Gräben umgeben sind, die mit polykristallinem Silizium von gleicher Dotierung aber höherer Leitfähigkeit wie die entsprechenden Wannen gefüllt sind und daß die dotierten Grabenfüllungen die Anschlußbereiche für die Kollektoren bilden.

In einer Version der Erfindung ist es möglich zwischen Grabenseitenwand und polykristalliner, dotierter Siliziumfüllung eine Isolationsschicht, vorzugsweise aus Siliziumoxid bestehend, anzuordnen.

Weitere Ausgestaltungen der Erfindung, insbesondere Verfahren zur Herstellung der erfindungsgemäßen Schaltung, sind aus den Unteransprüchen zu entnehmen.

Aus der erfindungsgemäßen Anordnung und der erfindungsgemäßen typischen Prozeßfolge zu ihrer Realisierung ergeben sich folgende Vorteile:

1. In BICMOS-Schaltungen wird durch das Vorhandensein der mit polykristallinem Silizium gefüllten Ätzgräben die Latch-up-Festigkeit bei gleichbleibenden Transistoreigenschaften erhöht, da die lateralen Anteile der parasitären Bipolartransistoren insbesondere bei Verwendung der fakultativen Oxidtrennschichten an den Seitenwänden der Gräben erheblich reduziert werden.

2. Bei Verwendung der fakultativen Oxidtrennschicht bei Kollektoranschlüssen wird die Kollektor-Substrat-Kapazität gegenüber einer reinen Sperrschichtkapazität verringert, bzw. bei gleichbleibender Kapazität ist eine höhere Substratdotierung und damit ein geringerer Abstand benachbarter Wannen möglich.

3. Die Verwendung von dotiertem Polysilizium als Kollektoranschluß erspart eine tiefe Kollektoranschlußimplantation und den dazugehörigen Diffusionsschritt (Diffusionszeit-Produkt).

4. Infolge der schnelleren Diffusion der Dotierstoffe im polykristallinen Silizium im Vergleich zu dem benachbarten einkristallinen Silizium wird die laterale Ausdiffusion des Kollektoranschlusses ins einkristalline Silizium gegenüber einer herkömmlichen Kollektoranschlußimplantation herabgesetzt.

5. Die laterale Ausdiffusion des Kollektoranschlusses wird bei Verwendung der fakultativen Oxidtrennschicht vermieden.

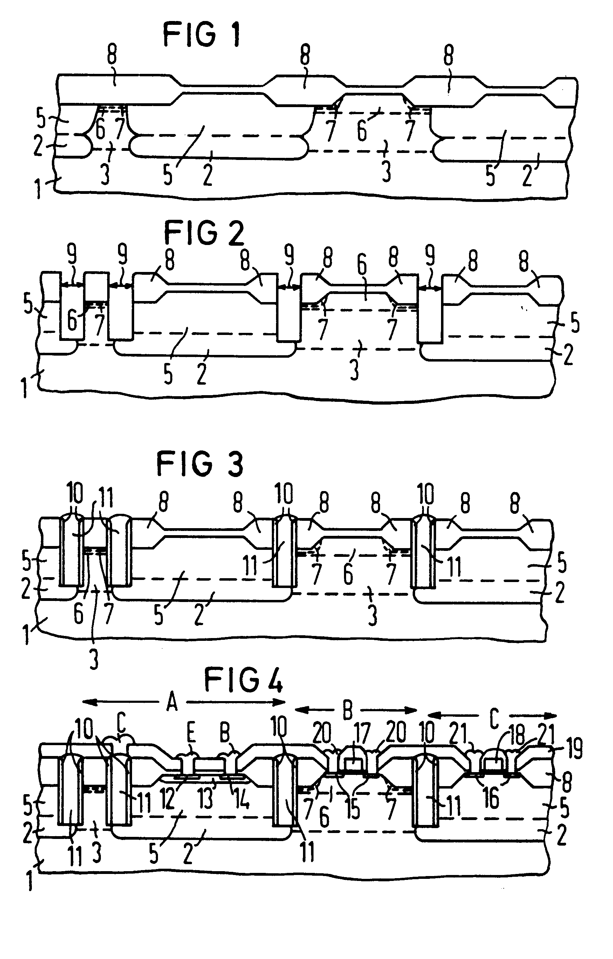

Im folgenden wird anhand von Ausführungsbeispielen und der Figuren 1 bis 4 der Prozeßablauf für die gleichzeitige Herstellung von bipolaren und komplementären MOS-Transistoren auf einem gemeinsamen Substrat (Chip) noch näher beschrieben. Dabei sind in den Figuren im Schnittbild die Verfahrensschritte zusammengefaßt dargestellt und für gleiche Teile gleiche Bezugszeichen verwendet. Die in den Figuren 1 bis 4 dargestellte Prozeßfolge gilt für einen n-Wannen-Bipolar-CMOS-Prozeß; sinngemäß läßt sich dieser auch auf einen p-Wannen-Prozeß übertragen.

Figur 1: In einem herkömmlichen Bipolar-CMOS-Prozeß werden Wannenbereiche und aktive Bereiche, wie vergrabener Kollektor und Kollektoranschluß, Kanalimplantationen, Feldimplantationen und Feldoxidbereiche durch folgende Verfahrensschritte definiert:

a) Herstellen der vergrabenen $n^+$-dotierten Zonen 2 im p-dotierten Substrat 1 (20 Ohm cm (100)-orientiert) durch Implantation von n-dotierenden Ionen (Antimon oder Arsen) nach vorheriger Photolackmaskierung der übrigen Bereiche,

b) ganzflächiges Aufbringen einer p-dotierten Epitaxieschicht 3 (20 Ohm cm) in einer Schichtdicke von 3 $\mu$m,

c) Erzeugung einer isolierenden Doppelschicht aus $SiO_2$ und Siliziumnitrid durch Abscheidung aus der Gasphase (in der Figur 1 nicht mehr enthalten),

d) Erzeugung der n-Wanne 5 im Substrat 1 durch Implantation von Phosphor-Ionen nach Ablösung der Siliziumnitridstrukturen über den n-Wannenbereichen 5 nach erfolgter Photolacktechnik,

e) Durchführung einer Oxidation zur Maskierung der n-Wannenbereiche 5 und gleichzeitig drivein von n-Wanne 5 (3 $\mu$m),

f) Durchführung einer Tiefimplantation von Bor-Ionen zur Herstellung eines oberflächenfernen Bereichs 6 der Kanalzone der n-Kanal-Transistoren (B),

g) Aufbringen einer aus Siliziumoxid und Siliziumnitrid bestehenden Doppelschicht und entsprechende Strukturierung der Siliziumnitridschicht (in der Figur 1 nicht mehr sichtbar) für die nachfolgende lokale Oxidation (LOCOS-Prozeß),

h) Durchführung einer Bor-Ionen-Implantation zur Dotierung der Feldbereiche der n-Kanal-Transistoren (B) nach vorheriger Photolackmaskierung der übrigen Bereiche der Schaltung; es entstehenden die p-dotierten Bereiche 7,

i) Durchführung des LOCOS-Prozesses zur Trennung der aktiven Transistorbereiche (A, B, C) und Erzeugung der Feldoxidbereiche 8 in einer Schichtdicke von 850 nm,

j) Ablösen der als Oxidationsmaske dienenden Siliziumnitridstruktur.

Die fertige Anordnung ist im Schnittbild in Figur 1 dargestellt. Nähere Einzelheiten über die Durchführung der einzelnen Prozeßschritte sind auch der eingangs genannten europäischen Patentanmeldung Nr. 86 10 64 83.3, insbesondere der Beschreibung zu den Figuren 1 bis 8 (hier allerdings mit tiefreichendem Kollektoranschluß, dessen Erzeugung bei der erfindungsgemäßen Anordnung nicht erforderlich ist) zu entnehmen.

Figur 2: Nun erfolgt der erfindungswesentliche Schritt des Einätzens der Gräben 9 in die Randbereiche der Wannen 5 (2) durch Trockenätzprozesse. Dazu wird eine entsprechende Photomaske auf die Anordnung gemäß Figur 1 aufgebracht und in den offengelegten Bereich der Photolackschicht (nicht dargestellt) zunächst eine $SiO_2$-Ätzung zur Beseitigung der Feldoxidbereiche (8) mit Trifluormethan und Sauerstoff ($CHF_3/O_2$) und dann eine Siliziumätzung zur Erzeugung der Ätzgräben 9 mit Bortrichlorid und Chlor ($BCl_3/Cl_2$) durchgeführt. Die Grabentiefe wird auf 2 - 3 $\mu$m eingestellt, das ist bis in die Bereiche der Epitaxieschicht 3.

Figur 3: Im Anschluß an die Grabenätzung (9) wird aus der Gasphase eine Zwischenoxidschicht abgeschieden und durch anisotrope Ätzung in Trifluormethan und Sauerstoff ($CHF_3/O_2$) soweit wieder entfernt, daß nur an den Seitenwänden der Gräben (9) eine $SiO_2$-Schicht 10 von ca. 100 nm Schichtdicke stehenbleibt. Das Füllen der Gräben 9, 10 mit $n^+$-dotierten polykristallinem Silizium 11 erfolgt durch Abscheidung von Silizium aus der Gasphase entweder bei der Abscheidung mit dem aus Arsen oder Phosphor bestehenden Dotierstoff gemischt oder durch nachträgliche Ionen-Implantation. Anschließend wird die dotierte Polysiliziumschicht 11 nach erfolgter Photolackmaskierung strukturiert.

Figur 4 zeigt die fertiggestellte, mit den Emitter-, Basis- und Kollektorbereichen und -anschlüssen, sowie den Source/Drain-Zonen und Gateelektroden und deren Anschlüssen versehene Anordnung. Diese Verfahrensschritte erfolgen in bekannter Weise, zum Beispiel wie in der bereits zitierten europäischen Patentanmeldung Nr. 86 106 483.3, insbesondere bei der Beschreibung der Figuren 9 bis 14, angegeben.

Es gelten außer den bereits bei Figur 3 angegebenen Bezugszeichen noch folgende:

12 = Emitterzone ($n^+$) von npn-Bipolartransistor A

13 = Basiszone (p) von npn-Bipolartransistor A

14 = Basisanschlußzone ($p^+$) von npn-Bipolartransistor A

15 = Source/Drain-Zone von n-Kanal-MOS-Transistor B

16 = Source/Drain-Zone von p-Kanal-MOS-Transistor C

17 = Gate-Elektrode von n-Kanal-MOS-Transistor B

18 = Gate-Elektrode von p-Kanal-MOS-Transistor C

19 = Zwischenoxid aus $SiO_2$.

C, E, B sind die Kollektor-, Emitter- und Basisanschlüsse aus Aluminium für den Bipolartransistor A;

20 und 21 bezeichnen die Source/Drain-Anschlüsse von n-Kanal- bzw. p-Kanal-Transistoren, ebenfalls aus Aluminium.

In einer Version des erfindungsgemäßen Verfahrens ist es auch möglich, die Oxidzwischenschicht 10 zwischen der $n^+$-dotierten Polysiliziumfüllung 11 und der Grabenseitenwand (9) wegzulassen. Dadurch wird der Prozeß zwar einfacher, doch muß eine gewisse laterale Ausdiffusion des Kollektoranschlusses in Kauf genommen werden.

**Patentansprüche**

1. Integrierte Bipolar (A)- und komplementäre MOS-Transistoren (B, C) auf einem gemeinsamen Substrat enthaltende Schaltung, bei der im p- bzw. n-dotierten Substrat n- bzw. p-dotierte Wannen vorgesehen sind, die p- bzw. n-Kanal-Transistoren aufnehmen oder isolierte npn- bzw. pnp Bipolartransistoren enthalten, wobei die n- bzw. p-dotierten Wannen den Kollektor des Transistors bilden, und bei der die n-bzw. p-Wannen vergrabene $n^+$- bzw. $p^+$-dotierte Zonen bedecken, die im Bipolartransistorbereich (A) durch tiefreichende Kollektoranschlüsse angeschlossen werden, **dadurch gekennzeichnet,** daß sowohl die, die p- bzw. n-Kanal-Transistoren aufnehmenden n- bzw. p-dotierten Wannen (5), als auch die, die npn- bzw. pnp-Bipolartransistoren enthaltenden Wannen (5) im Substrat (1) von Gräben (9) umgeben sind, die mit polykristallinem Silizium (11) von gleicher Dotierung aber höherer Leitfähigkeit wie die entsprechenden Wannen (5) gefüllt sind, und daß die dotierten Grabenfüllungen (11) die Anschlußbereiche für die Kollektoren bilden.

2. Integrierte Halbleiterschaltung nach Anspruch 1, **dadurch gekennzeichnet,** daß zwischen Grabenseitenwand (9) und polykristalliner dotierter Siliziumfüllung (11) eine Isolationsschicht (10) angeordnet ist.

3. Integrierte Halbleiterschaltung nach Anspruch 2, **dadurch gekennzeichnet,** daß die Isolationsschicht (10) aus Siliziumoxid besteht.

4. Verfahren zum Herstellen von einer bipolare (A) und komplementäre MOS (CMOS) Transistoren (B, C) auf einem gemeinsamen Substrat enthaltenden integrierten Schaltung nach Anspruch 1, bei dem für die Aufnahme der p- bzw. n-Kanal-Transistoren im p- bzw. n-dotierten Siliziumsubstrat n- bzw. p-dotierte Wannen erzeugt werden und in die n- bzw. p-dotierten Wannen isolierte npn- bzw. pnp-Bipolartransistoren (A) gelegt werden, wobei die n- bzw. p-Wannen den Kollektor des Transistors (A) bilden und bei dem die n- bzw. p-Wannen vergrabene $n^+$- bzw. $p^+$-dotierte Zonen bedecken, die im Bipolartransistorbereich (A) durch tiefreichende Kollektoranschlüsse angeschlossen werden, **gekennzeichnet durch** folgende Verfahrensschritte:

a) Herstellen der vergrabenen $n^+$- bzw. $p^+$-dotierten Zonen (2) im p- bzw. n-dotierten Substrat (1),

b) ganzflächigem Aufbringen einer p- bzw. n-dotierten Epitaxieschicht (3),

c) Erzeugen der n- bzw. p-Wannen (5) im Substrat (1) durch Implantation von n- bzw. p-dotierenden Ionen und Eindiffusion der implantierten Ionen in das Substrat (1),

d) Durchführung der Tiefimplantation zur Herstellung des oberflächenfernen Bereichs (6) der Kanalzone der n- bzw. p-Transistoren (B, C) und

e) Herstellung des für die Trennung der aktiven Transistorbereiche (A, B, C) im Substrat (1) erforderlichen Feldoxids (8) durch lokale Oxidation unter Verwendung einer Siliziumnitridstruktur als Oxidationsmaske,

f) in den seitlichen Randbereichen der Wannen (5) nach erfolgter Photolithographie Ätzgruben (9) bis zur Tiefe der Epitaxieschicht (3) erzeugt werden,

g) die Ätzgruben (9) mit $n^+$- bzw. $p^+$-dotierten, polykristallinen Silizium (11) durch ganzflächige Abscheidung und Strukturierung gefüllt werden und

h) anschließend in bekannter Weise die bipolaren (A) und komplementären MOS (CMOS) Transistoren (B, C) erzeugt und mit Zwischenisolationsschichten (19) und Metallisierungen (20, 21) versehen werden.

5. Verfahren nach Anspruch 4, **dadurch gekennzeichnet,** daß vor der Füllung der Ätzgruben (9) eine Zwischenoxidschicht (10) aufgebracht wird und durch anisotrope Ätzung bis auf die Seitenwände der Ätzgruben (9) wieder entfernt wird.

6. Verfahren zum Herstellen von einer bipolare (A) und komplementäre MOS (CMOS)-Transistoren (B, C) auf einem gemeinsamen Siliziumsubstrat (1) enthaltenden integrierten Schaltung nach Anspruch 1, bei dem für die Aufnahme der p-Kanal-Transistoren (C) im p-dotierten Siliziumsubstrat (1) n-dotierte Wannen (5) erzeugt werden und in die n-dotierten Wannen (5) isolierte npn-Bipolartransistoren (A) gelegt werden, wobei die n-Wanne (5) den Kollektor des Transistors (A) bildet und bei dem die n-Wannen (5) vergrabene $n^+$-dotierte Zonen (2) bedecken, die im Bipolartransistorbereich (A) durch tiefreichende Kollektoranschlüsse angeschlossen werden, **gekennzeichnet durch** den Ablauf folgender Verfahrensschritte:

a) Herstellen der vergrabenen $n^+$-dotierten Zonen (2) im p-dotierten Substrat (1) durch Implantation von n-dotierenden Ionen nach vorheriger Maskierung der übrigen Bereiche,

b) ganzflächiges Aufbringen einer p-dotierten Epitaxieschicht (3),

c) Erzeugung einer ganzflächigen Isolations-Doppelschicht aus Siliziumoxid und Siliziumnitrid,

d) Erzeugen der n-Wannen (5) im Substrat (1) durch Implantation von n-dotierenden Ionen nach Ablösen der Siliziumnitridstrukturen über den n-Wannenbereichen (5),

e) Eindiffusion der implantierten, n-dotierenden Ionen in das Substrat (1) und gleichzeitige Oxidation der Oberfläche in den n-Wannenbereichen (5),

f) Durchführung einer Tiefimplantation von Bor-Ionen zur Herstellung eines oberflächenfernen Bereichs (6) der Kanalzone der n-Transistoren (B) nach Entfernung der Siliziumnitridstrukturen, wobei das Oxid als Maske wirkt,

g) Aufbringen einer aus Siliziumoxid und Siliziumnitrid bestehenden Doppelschicht und entsprechende Strukturierung der Siliziumnitridschicht für die nachfolgende lokale Oxidation,

h) Durchführung einer Bor-Ionen-Implantation zur Dotierung der Feldoxidbereiche (7) der n-Kanal-Transistoren nach vorheriger Photolackmaskierung der übrigen Bereiche,

i) Herstellung des für die Trennung der aktiven Transistorbereiche (A, B, C) im Substrat (1) erforderlichen Feldoxids (8) durch lokale Oxidation nach Entfernung der Photolackmaske und unter Verwendung der Siliziumnitrid-Struktur als Oxidationsmaske,

j) Erzeugung von Ätzgruben (9) in den seitlichen Randbereichen der Wannen (5) bis zur Tiefe der p-dotierten Epitaxieschicht (3) durch selektives $SiO_2$- und Silizium-Ätzen nach erfolgter Photolithographie,

k) Abscheidung eines Zwischenoxids (10),

l) Durchführung einer anisotropen Oxidätzung, so daß an den Seitenwänden der Ätzgruben (9) eine $SiO_2$-Schicht (10) stehenbleibt,

m) ganzflächige Abscheidung von polykristallinem Silizium (11) und nachfolgende Dotierung mit $n^+$-dotierenden Ionen durch Ionenimplantation und Diffusion,

n) Strukturierung des $n^+$-dotierten polykristallinen Siliziums (11) nach erfolgter Photolithographie, so daß eine $n^+$-dotierte Grabenfüllung (11) entsteht,

o) Herstellung der Basiszone (13) im Bipolartransistorbereich (A) durch Bor-Ionen-Implantation nach vorheriger Photolackmaskierung der übrigen Bereiche,

p) ganzflächige Oxidation zur Erzeugung des Gateoxids nach Entfernung der Photolackmaske und des Streuoxids,

q) Durchführung einer ganzflächigen, flachen Bor-Ionen-Implantation zur Dotierung der Kanalbereiche der n-bzw. p-Kanal-MOS-Transistoren,

r) Herstellung der Gate-Elektroden (17, 18) der MOS-Transistoren (B, C) durch ganzflächige Abscheidung des Gatematerials mit anschließender Strukturierung,

s) Abscheidung einer ganzflächigen, als Zwischenoxid wirkenden Siliziumoxid-Schicht (19) aus der Gasphase,

t) gleichzeitige Herstellung der Source/Drain-Bereiche (15) der n-Kanal-Transistoren (B), des Emitters (12) und des $n^+$-Kollektorkontakts der Bipolartransistoren (A) durch Implantation von n-dotierenden Ionen nach vorheriger Photolackmaskierung der p-Kanal-Transistorbereiche (C) und der Bipolartransistorbereiche (A) mit Ausnahme des Emitterbereichs und des n$^+$-Kollektorbereichs,

u) gleichzeitige Herstellung der Source/Drain-Bereiche (16) der p-Kanal-Transistoren (C) und des p$^+$-Basiskontakts (14) der Bipolartransistoren (A) durch Bor-Ionen-Implantation nach vorheriger Photolackmaskierung der n-Kanal-Transistorbereiche (B) und der Bipolartransistorbereiche (A) mit Ausnahme des p$^+$-Basisbereichs (14),

v) Entfernung der Photolackmaske, Freilegung der Kontaktlochbereiche, Durchführung der Metallisierung (C, E, B, 20, 21) zur Herstellung der Anschlußelektroden und Passivierung.

7. Verfahren nach Anspruch 6, **dadurch gekennzeichnet,** daß die Dotierung der polykristallinen Siliziumfüllung (11) mit n$^+$-Dotierungsstoffen bereits bei der Abscheidung durchgeführt wird.

8. Verfahren nach Anspruch 6 und 7, **dadurch gekennzeichnet,** daß die Verfahrensschritte k) und l) entfallen.

9. Verfahren nach einem der Ansprüche 6 bis 8, **dadurch gekennzeichnet,** daß ein p-dotiertes, (100)-orientiertes Siliziumsubstrat (1) mit einem spezifischen elektrischen Widerstand von 20 Ohm cm verwendet wird.

## Claims

1. Integrated circuit which contains bipolar (A) and complementary MOS transistors (B, C) on a common substrate and in which there are provided in the p- or n-doped substrate n- or p-doped wells, respectively, which accommodate p- or n-channel transistors, respectively, or contain insulated n-p-n or p-n-p bipolar transistors respectively, the n- or p-doped wells forming the collector of the transistor, and in which the n- or p-type wells cover buried n$^+$- or p$^+$-doped zones, respectively, which are connected in the bipolar transistor region (A) by deeply extending collector terminals, characterised in that both the n- or p-doped wells (5) accommodating the p- or n-channel transistors, respectively, and the wells (5) containing the n-p-n or p-n-p bipolar transistors are surrounded, in the substrate (1), by trenches (9) which are filled with polycrystalline silicon (11) of the same doping but higher conductivity than the corresponding wells (5), and in that the doped trench fillings (11) form the terminal regions for the collectors.

2. Integrated semiconductor circuit according to Claim 1, characterised in that an insulation layer (10) is disposed between trench side wall (9) and polycrystalline doped silicon filling (11).

3. Integrated semiconductor circuit according to Claim 2, characterised in that the insulation layer (10) is composed of silicon oxide.

4. Method for manufacturing an integrated circuit according to Claim 1 which contains bipolar (A) and complementary MOS (CMOS) transistors (B, C) on a common substrate and in which n- or p-doped wells are produced for accommodating the p- or n-channel transistors in the p- or n-doped silicon substrate, respectively, and insulated n-p-n or p-n-p bipolar transistors (A) are laid in the n- or p-doped wells respectively, the n- or p-type wells forming the collector of the transistor (A), and in which the n- or p-type wells cover buried n$^+$- or p$^+$-doped zones, respectively, which are connected in the bipolar transistor region (A) by deeply extending collector terminals, characterised by the following method steps:

a) production of the buried n$^+$- or p$^+$-doped zones (2) in the p- or n-doped substrate (1), respectively,

b) application of a p- or n-doped epitaxial layer (3) over the entire surface,

c) production of the n- or p-type wells (5) in the substrate (1) by implantation of n- or p-doping ions, respectively, and drive-in of the implanted ions into the substrate (1),

d) performance of the deep implantation to produce the surface-remote region (6) of the channel zone of the n- or p-type transistors (B, C), respectively, and

e) production of the field oxide (8) necessary for the isolation of the active transistor regions (A, B, C) in the substrate (1) by local oxidation using a silicon nitride structure as oxidation mask,

f) etched trenches (9) are produced down to the depth of the epitaxial layer (3) in the lateral peripheral regions of the wells (5) after photolithography has been carried out,

g) the etched trenches (9) are filled with n$^+$- or p$^+$-doped polycrystalline silicon (11) by deposition over the entire surface and structuring, and

h) the bipolar (A) and complementary MOS (CMOS) transistors (B, C) are then produced in a known manner and provided with insulating interlayers (19) and metallisations (20, 21).

5. Method according to Claim 4, characterised in that an oxide interlayer (10) is applied before the etched trenches (9) are filled and is removed again by anisotropic etching up to the side walls of the etched trenches (9).

6. Method for manufacturing an integrated circuit according to Claim 1 which contains bipolar (A) and complementary MOS (CMOS) transistors (B, C) on a common silicon substrate (1) and in which n-doped wells (5) are produced for accommodating the p-channel transistors (C) in the p-doped silicon substrate (1) and insulated n-p-n bipolar transistors (A) are laid in the n-doped wells (5), the n-type well (5) forming the collector of the transistor (A), and in which the n-type wells (5) cover buried $n^+$-doped zones (2) which are connected in the bipolar transistor region (A) by deeply extending collector terminals, characterised by the sequence of the following method steps:

a) production of the buried $n^+$-doped zones (2) in the p-doped substrate (1) by implantation of n-doping ions after prior masking of the remaining regions,

b) application of a p-doped epitaxial layer (3) over the entire surface,

c) production of an insulating double layer of silicon oxide and silicon nitride over the entire surface,

d) production of the n-type wells (5) in the substrate (1) by implantation of n-doping ions after stripping the silicon nitride structures above the n-type well regions (5),

e) drive-in of the implanted n-doping ions into the substrate (1) and simultaneous oxidation of the surface in the n-type well regions (5),

f) performance of a deep implantation of boron ions to produce a surface-remote region (6) of the channel zone of the n-type transistors (B) after removal of the silicon nitride structures, the oxide acting as mask,

g) application of a double layer composed of silicon oxide and silicon nitride and suitable structuring of the silicon nitride layer for the subsequent local oxidation,

h) performance of a boron ion implantation to dope the field oxide regions (7) of the n-channel transistors after prior photoresist masking of the remaining regions,

i) production of the field oxide (8) necessary for the isolation of the active transistor regions (A, B, C) in the substrate (1) by local oxidation after removal of the photoresist mask and using the silicon nitride structure as oxidation mask,

j) production of etched trenches (9) in the lateral peripheral regions of the wells (5) down to the depth of the p-doped epitaxial layer (3) by selective $SiO_2$ and silicon etches after photolithography has been carried out,

k) deposition of a intermediate oxide (10),

l) performance of an anisotropic oxide etching so that an $SiO_2$ layer (10) remains on the side walls of the etched trenches (9),

m) deposition of polycrystalline silicon (11) over the entire surface and subsequent doping with $n^+$-doping ions by ion implantation and diffusion,

n) structuring of the $n^+$-doped polycrystalline silicon (11) after photolithography has been carried out so that an $n^+$-doped trench filling (11) is produced,

o) production of the base zone (13) in the bipolar transistor region (A) by boron ion implantation after prior photoresist masking of the remaining regions,

p) oxidation over the entire surface to produce the gate oxide after removing the photoresist mask and the scattered oxide,

q) performance of a shallow boron ion implantation over the entire surface to dope the channel regions of the n- or p-channel MOS transistors,

r) production of the gate electrodes (17, 18) of the MOS transistors (B, C) by deposition of the gate material over the entire surface with subsequent structuring,

s) deposition of a silicon oxide layer (19) over the entire surface from the gas phase, which layer acts as intermediate oxide,

t) simultaneous production of the source/drain regions (15) of the n-channel transistors (B), of the emitter (12) and of the $n^+$-type collector contact of the bipolar transistors (A) by implantation of n-doping ions after prior photoresist masking of the p-channel transistor regions (C) and of the bipolar transistor regions (A) with the exception of the emitter region and of the $n^+$-type collector region,

u) simultaneous production of the source/drain regions (16) of the p-channel transistors (C) and of the $p^+$-type base contact (14) of the bipolar transistors (A) by boron ion implantation after prior photoresist masking of the n-channel transistor regions (B) and of the bipolar transistor regions (A) with the exception of the $p^+$-type base region (14),

v) removal of the photoresist mask, exposure of the via regions, performance of the metallisation (C, E, B, 20, 21) to produce the terminal electrodes, and passivation.

7. Method according to Claim 6, characterised in that the doping of the polycrystalline silicon filling (11) containing $n^+$-type dopants is already performed during the deposition.

8. Method according to Claims 6 and 7, characterised in that the method steps k) and l) are omitted.

9. Method according to any of Claims 6 to 8, characterised in that a p-doped (100)-oriented silicon substrate (1) having a specific electrical resistance of 20 Ω.cm is used.

**Revendications**

1. Circuit contenant des transistors bipolaires intégrés (A) et des transistors MOS complémentaires intégrés (B,C) sur un substrat commun, et dans lequel dans le substrat dopé du type p ou du type n sont prévues des cuvettes dopées du type n et du type p, qui reçoivent des transistors à canal p ou à canal n ou contiennent des transistors bipolaires npn ou pnp isolés, et dans lequel les cuvettes dopées du type n ou p forment le collecteur du transistor et les cuvettes de type n ou p recouvrent des zones ensevelies dopées du type $n^+$ ou $p^+$ et qui sont raccordées, dans la région du transistor bipolaire (A) par des bornes profondes de collecteur, caractérisé par le fait qu'aussi bien les cuvettes (5) dopées du type n ou p, qui logent les transistors à canal p ou n que les cuvettes (5) contenant les transistors bipolaires npn ou pnp sont entourées, dans le substrat (1), par des sillons (9), qui sont remplis par du silicium polycristallin (11) possédant le même dopage que les cuvettes correspondantes (5), mais une conductivité supérieure, et que les remplissages dopés (11) des sillons forment les zones de raccordement pour les collecteurs.

2. Circuit intégré à semiconducteurs suivant la revendication 1, caractérisé par le fait qu'une couche isolante (10) est disposée entre la paroi latérale (9) des sillons et le remplissage en silicium polycristallin dopé (11).

3. Circuit intégré à semiconducteurs selon la revendication 2, caractérisé par le fait que la couche isolante (10) est formée d'oxyde de silicium.

4. Procédé pour fabriquer un circuit intégré contenant des transistors bipolaires (A) et des transistors MOS complémentaires (CMOS) (B,C) sur un substrat commun, suivant la revendication 1, et selon lequel pour loger les transistors à canal de type p ou n dans le substrat en silicium dopé du type p ou n, on forme des cuvettes dopées du type n ou p et dans les cuvettes dopées du type n ou p, on dépose des transistors bipolaires npn ou pnp (A) isolés, les cuvettes de type n ou p formant le collecteur du transistor (A), et selon lequel les cuvettes de type n ou p recouvrent les zones ensevelies dopées de type $n^+$ ou $p^+$, qui sont raccordées dans la zone (A) du transistor bipolaire par des bornes profondes de collecteur, caractérisé par les étapes opératoires suivantes :

a) fabrication des zones ensevelies (2) dopées du type $n^+$ ou $p^+$ dans le substrat (1) dopé de type p ou n,

b) dépôt, sur toute la surface, d'une couche épitaxiale (3) dopée du type p ou n,

c) production des cuvettes (5) de type n ou p dans le substrat (1) par implantation d'ions réalisant un dopage de type n ou p, et diffusion des ions implantés dans le substrat (1),

d) exécution de l'implantation profonde pour fabriquer la région (6), éloignée de la surface, de la zone de canal du transistor de type n et p (B,C), et

e) fabrication de l'oxyde de champ (8) nécessaire pour la séparation des régions actives (A,B,C) des transistors dans le substrat (1), par oxydation locale, moyennant l'utilisation d'une structure de nitrure de silicium en tant que masque d'oxydation,

f) on forme dans les zones marginales latérales des cuvettes (5), après exécution de la photolithographie, des sillons (9) par corrosion jusqu'à la profondeur de la couche épitaxiale (3),

g) on remplit les sillons (9) formés par corrosion avec du silicium polycristallin (11) dopé du type $n^+$ ou $p^+$, au moyen d'un dépôt et d'une structuration sur l'ensemble de la surface, et

h) de façon connue, on forme ensuite les transistors bipolaires (A) et les transistors MOS complémentaires CMOS (B,C), et on les équipe de couches isolantes intercalaires (19) et de métallisations (20,21).

5. Procédé suivant la revendication 4, caractérisé par le fait qu'avant le remplissage des sillons (9) formés par corrosion, on dépose une couche d'oxyde intercalaire (10) et on l'élimine à nouveau par corrosion anisotrope jusqu'au niveau des parois latérales des sillons (9) formés par corrosion.

6. Procédé pour fabriquer un circuit intégré contenant des transistors bipolaires (A) et des transistors MOS complémentaires (CMOS) (B,C) sur un substrat en silicium commun (1), selon lequel, pour loger les transistors à canal p (C), on forme des cuvettes (5) dopées du type n dans le substrat en silicium (1) dopé du type p, et on dépose des transistors bipolaires npn isolés (A) dans les cuvettes (5) dopées du type n, la cuvette (5) de type n constituant le collecteur du transistor (A), et selon lequel les cuvettes (5) de type n recouvrent les zones ensevelies (2) de type $n^+$, qui sont raccordées, dans la région (A) des transistors bipolaires, par des bornes profondes de collecteur, caractérisé par l'exécution des étapes opératoires suivantes :

a) fabrication des zones ensevelies (2) dopées du type $n^+$ dans le substrat (1) dopé du type p, par implantation d'ions réalisant un dopage de type n, après masquage préalable des autres régions,

b) dépôt, sur toute la surface, d'une couche épitaxiale (3) dopée du type p,

c) production d'une couche isolante double, en bioxyde de silicium et en nitrure de silicium, sur toute la surface,

d) production des cuvettes (5) de type n dans le substrat (1) par implantation d'ions réalisant un dopage de type n, après élimination par dissolution des structures en nitrure de silicium au-dessus des régions (5) des cuvettes de type n,

e) diffusion des ions implantés, réalisant un dopage de type n, dans le substrat (1), et oxydation simultanée des surfaces dans les régions (5) des cuvettes de type n,

f) exécution d'une implantation profonde d'ions de bore pour la fabrication d'une région (6), éloignée de la surface, de la zone du canal des transistors de type n (B), après élimination des structures de nitrure de silicium, l'oxyde agissant en tant que masque,

g) dépôt d'une couche double constituée d'oxyde de silicium et de nitrure de silicium et structuration correspondante de la couche de nitrure de silicium pour l'oxydation locale ultérieure,

h) exécution d'une implantation d'ions de bore pour réaliser le dopage des régions (7) d'oxyde de champ du transistor à canal n après masquage préalable des autres régions à l'aide d'une photolaque,

i) fabrication de l'oxyde de champ (8), nécessaire pour la séparation des régions actives des transistors (A,B,C) dans le substrat (1), par oxydation locale après élimination du masque de photolaque et moyennant l'utilisation de la structure de nitrure de silicium en tant que masque d'oxydation,

j) production de sillons (9) formés par corrosion dans les régions marginales latérales des cuvettes (5) jusqu'à la profondeur de la couche épitaxiale (3) dopée de type p, au moyen de la corrosion sélective du $SiO_2$ et du silicium, après mise en oeuvre de la photolithographie,

k) dépôt d'un oxyde intercalaire (10),

l) exécution d'une corrosion anisotrope de l'oxyde de manière qu'une couche (10) de $SiO_2$ subsiste sur les parois latérales des sillons (9) formés par corrosion,

m) dépôt, sur toute la surface, de silicium polycristallin (11) et dopage ultérieur avec des ions réalisant un dopage de type $n^+$ par implantation d'ions et diffusion,

n) structuration du silicium polycristallin (11) dopé du type $n^+$ après exécution de la photolithographie, de manière à faire apparaître un remplissage (11) des sillons, du type $n^+$,

o) fabrication de la zone de base (13) dans la région (A) du transistor bipolaire par implantation d'ions de bore après masquage préalable des autres zones par une photolaque,

p) oxydation, sur toute la surface, pour la production de l'oxyde de grille après élimination du masque de photolaque et de l'oxyde de diffusion,

q) exécution d'une implantation de faible profondeur d'ions de bore, sur toute la surface, pour réaliser le dopage des régions de canal des transistors MOS à canal n et à canal p,

r) fabrication des électrodes de grille (17,18) des transistors MOS (B,C) par dépôt, sur toute la surface, du matériau de la grille, avec structuration ultérieure,

s) dépôt d'une couche d'oxyde de silicium (19), qui s'étend sur toute la surface et agit en tant qu'oxyde intercalaire, à partir de la phase gazeuse,

t) fabrication simultanée des régions de source/drain (15) du transistor à canal n (B), de l'émetteur (12) et du contact de collecteur de type $n^+$ des transistors bipolaires (A) par implantation d'ions réalisant un dopage de type n après masquage préalable au moyen d'une photolaque des régions (C) des transistors à canal p et des régions (A) des transistors bipolaires, à l'exception de la région d'émetteur et de la région de collecteur de type n$^+$,

u) fabrication simultanée des régions de source/drain (16) des transistors (C) à canal p et du contact de base de type p$^+$ (14) des transistors bipolaires (A) par implantation d'ions de bore après masquage préalable, avec une photolaque, des régions (B) des transistors à canal n et des régions (A) du transistor bipolaire, à l'exception de la région de base de type p$^+$ (14),

v) élimination du masque de photolaque, libération des régions des trous de contact, exécution de la métallisation (C,E,B,20,21) pour la fabrication des électrodes de raccordement et pour la passivation.

7. Procédé suivant la revendication 6, caractérisé en ce que le dopage du remplissage du silicium polycristallin (11) avec les substances dopantes de type n$^+$ est exécuté déjà lors du dépôt.

8. Procédé suivant les revendications 6 ou 7, caractérisé par le fait que les étapes opératoires k) et l) sont supprimées.

9. Procédé suivant l'une des revendications 6 à 8, caractérisé par le fait qu'on utilise un substrat en silicium (1) dopé du type p, possédant l'orientation (100) et présentant une résistance électrique spécifique égale à 20 ohms.cm.

## FIG 1

## FIG 2

## FIG 3

## FIG 4